Europäisches Patentamt

European Patent Office

Office européen des brevets

(19)

(11) Numéro de publication: **0 147 268**
**B1**

(12) **FASCICULE DE BREVET EUROPEEN**

(45) Date de publication du fascicule du brevet:
**09.03.88**

(51) Int. Cl.⁴: **G 11 C 8/00**

(21) Numéro de dépôt: **84402318.4**

(22) Date de dépôt: **14.11.84**

(54) **Dispositif d'adressage de memoire.**

(30) Priorité: **15.11.83 FR 8318090**

(43) Date de publication de la demande:
**03.07.85 Bulletin 85/27**

(45) Mention de la délivrance du brevet:
**09.03.88 Bulletin 88/10**

(84) Etats contractants désignés:
**BE DE GB IT NL**

(56) Documents cités:
**FR - A - 2 507 372**
**US - A - 3 893 088**
**US - A - 4 280 199**
**US - A - 4 393 482**

**IBM TECHNICAL DISCLOSURE BULLETIN, vol. 14, no. 4,**
**septembre 1971, pages 1056-1057, New York, US; M.S.**
**AXELROD et al.: "Programmable logic chip"**
**PATENTS ABSTRACTS OF JAPAN, vol. 6, no. 82**
**(P-116)[960], 20 mai 1982**
**PATENTS ABSTRACTS OF JAPAN, vol. 6, no. 51**
**(P-108)[929], 6 avril 1982**

(73) Titulaire: **SOCIETE ANONYME DE**
**TELECOMMUNICATIONS, 41, rue Cantagrel,**
**F-75624 Paris Cedex 13 (FR)**

(72) Inventeur: **Aguille, Gérard, 41, rue Cantagrel,**
**F-75624 Paris Cedex 13 (FR)**
Inventeur: **Jolivet, Jean-Claude R., 41, rue Cantagrel,**
**F-75624 Paris Cedex 13 (FR)**

(74) Mandataire: **Martinet & Lapoux, 62, rue des Mathurins,**
**F-75008 Paris (FR)**

# Description

La présente invention concerne un dispositif d'adressage d'une mémoire notamment dynamique délivrant des mots d'adresses composés chacun de premier et second mots d'adresse contenant des bits de poids faible et des bits de poids fort du mot d'adresse. D'une manière générale, l'invention a trait à l'adressage séquentiel d'une mémoire, telle que celles utilisées dans des systèmes numériques de vidéocommunication où il est nécessaire de faire un traitement interimage et/ou un infraimage.

Les mémoires présentent généralement des capacités de 4K, 16K, 64 ou 256 Kbits, l'entier K étant égal à $2^{10}$ = 1024. Ainsi pour une mémoire ayant une capacité de 64 Kbits, il est nécessaire de disposer de mots d'adresses ayant 6+10 = 16 bits pour adresser des cellules de 1 bit de la mémoire. Afin de limiter le nombre de fils du bus d'entrée d'adressage de la mémoire et donc le nombre de broches du boîtier du circuit intégré contenant la mémoire, chaque mot d'adresse de 16 bits est partagé en deux mots à 8 bits parallèles transmis en série. Le premier mot contient les 8 bits de poids faible du mot d'adresse et le second mot contient les 8 bits de poids fort du mot d'adresse.

Lorsque la mémoire est du type à adressage alterné en lecture et écriture, des premier et second mots d'adresse de lecture et des premier et second mots d'adresse d'écriture sont transmis successivement dans un bus d'adressage à 8 fils à la mémoire pendant une période d'horloge définissant un cycle d'adressage d'une cellule de mémoire. En pratique, les cellules de mémoire sont disposées dans une matrice à rangées et colonnes et chaque cellule au croisement d'une rangée et d'une colonne est adressée par un premier mot à 8 bits indiquant le numéro de la rangée correspondant à la cellule et par un second mot à 8 bits indiquant le numéro de la colonne correspondant à la cellule.

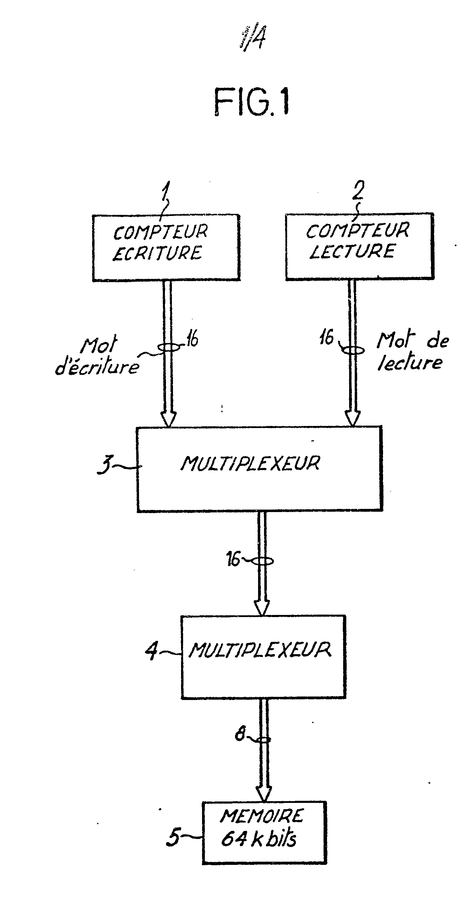

Comme montré schématiquement à la fig. 1, un dispositif d'adressage pour une telle mémoire 5 à 64 Kbits comprend un compteur d'écriture à 16 bits 1 et un compteur de lecture à 16 bits 2 qui délivrent simultanément un mot d'adresse d'écriture à 16 bits et un mot d'adresse de lecture à 16 bits pendant chaque période d'horloge, respectivement. Les mots d'adresse de lecture et d'écriture sont multiplexés dans un bus à 16 fils en sortie d'un multiplexeur 3. Puis les mots d'adresse à 16 bits multiplexés sont multiplexés en mots à 8 bits parallèles dans un second multiplexeur 4 ayant un bus de sortie délivrant des premiers et seconds mots d'adresse de lecture à 8 bits et des premiers et seconds mots d'adresse d'écriture à 8 bits à huit entrées d'adressage de la mémoire 5.

En technologie de circuits intégrés à transistor TTL par exemple, le dispositif d'adressage montré à la fig. 1 nécessite quatre boîtiers pour chaque compteur 1, 2, quatre boîtiers pour le multiplexeur 3 et deux boîtiers pour le multiplexeur 4, soit quatorze boîtiers de circuit intégré au total.

La présente invention a pour but de fournir un dispositif d'adressage de mémoire plus économique en nombre de boîtiers de circuit intégré et, par suite, moins onéreux que ceux selon la technique antérieure.

A cette fin, un dispositif d'adressage d'une mémoire est tel que défini dans la revendication 1.

Grâce au bouclage des moyens à décalage à travers les moyens pour incrémenter, les moyens pour incrémenter remplissent des fonctions analogues aux compteurs d'écriture et de lecture selon la technique antérieure, en soumettant à une opération d'addition chaque mot d'adresse, et plus précisément chacun des premiers et seconds mots d'adresse. En outre, les moyens pour incrémenter sont réalisés par un circuit d'addition connu et quelques composants électroniques simples, ce qui diminue le coût et surtout l'encombrement du dispositif d'adressage.

Le multiplexage des premiers et seconds mots d'adresse est réalisé en permanence dans les moyens à décalage. Les moyens à décalage peuvent comprendre quatre circuits à P bascules chacun, où P est égal au nombre de bits des premiers et seconds mots d'adresse pour une mémoire à $2^{2P}$ cellules, lorsque la mémoire est adressable alternativement en lecture et écriture.

D'autres avantages de la présente invention apparaîtront plus clairement à la lecture de la description suivante de plusieurs réalisations préférées de l'invention en référence aux dessins annexés correspondants dans lesquels:

– la fig. 1 est un bloc-diagramme schématique d'un dispositif d'adressage de mémoire selon la technique antérieure;

– la fig. 2 est un bloc-diagramme d'un dispositif d'adressage pour une mémoire à adressage alterné en lecture et écriture selon une première réalisation;

– la fig. 3 est un bloc-diagramme d'un dispositif d'adressage pour une mémoire à adressage simultané en lecture et écriture selon une seconde réalisation; et

– la fig. 4 est un bloc-diagramme d'un dispositif d'adressage pour une mémoire à adressage alterné en lecture et écriture, permettant des sauts d'adresse et une synchronisation de la mémoire, selon une troisième réalisation.

Dans la suite, on se réfère à titre d'exemple à une mémoire dynamique 5 ayant une capacité de 64 Kbits. La mémoire 5 contient ainsi $2^{2P} = 2^{16} = 65\,536$ cellules de mémoire capables de mémoriser chacune un mot de 1 bit. Selon d'autres variantes, chaque cellule de mémoire peut mémoriser un mot ayant un nombre prédéterminé de bits, par exemple égal à 8, 16 ou 20. Des données d sérialisées sont appliquées à une entrée 50 de la mémoire 5. Une sortie 51 de la mémoire délivre des bits de donnée lus dans la mémoire. Les cellules sont adressables par des adresses numérotées 0 à $A = 2^{16} - 1 = 65\,535$. Chaque adresse de cellule a, où a est compris entre 0 et A, est codé en un mot d'adresse binaire ayant 2P = 16 bits. Chaque mot d'adresse a est composé d'un premier mot $a_1$ à P = 8 bits incluant les bits de poids faible du mot d'adresse et d'un second mot $a_2$ à P = 8 bits

incluant les bits de poids fort du mot d'adresse. Les premiers mots $a_1$ sont compris entre 0 et $2^P - 1 = 255$, et les seconds mots $a_2$ sont également compris entre 0 et $2^P - 1 = 255$. Ainsi une adresse a est égale à $a_1 + 256\ a_2$. Lorsque les cellules 0 à A sont adressées séquenciellement, la mémoire est adressée d'abord par des mots d'adresse 0+0 à 256+0, puis 0+256 à 255+256 et ainsi de suite jusqu'à 0+(256×255) à $255+(256\times255) = 2^{2P} - 1$. Aussi, lorsqu'une adresse a+1 succède à une adresse a ayant toutes deux un même second mot $a_2$, le mot d'adresse a+1 est déduit du mot d'adresse a en incrémentant d'une unité le premier mot $a_1$ du mot a. Lorsqu'une suite de mots d'adresse $0+256a_2$ à $255+256\ a_2$ est balayée, on passe à la suite de mots d'adresse suivant $0+256a_2$ à $255+256\ (a_2+1)$ en incrémentant d'une unité le second mot $a_2$ de la suite précédente. Ainsi pour adresser successivement les cellules 0 à $2^{2P} - 1$ de la mémoire 5, on effectue une addition d'une unité modulo sur le premier mot $a_1$ pour chaque suite de 256 mots d'adresse, et on effectue une addition d'une unité modulo 256 sur le second mot $a_2$ pour passer d'une suite de 256 mots à la suivante.

Les dispositifs d'adressage selon l'invention décrits ci-après sont fondés sur les opérations décrites ci-dessus. Dans les réalisations décrites ci-dessous, des circuits annexes à la mémoire, tels que base de temps, circuits d'autorisation d'écriture et de lecture et analogues, ne sont pas montrés.

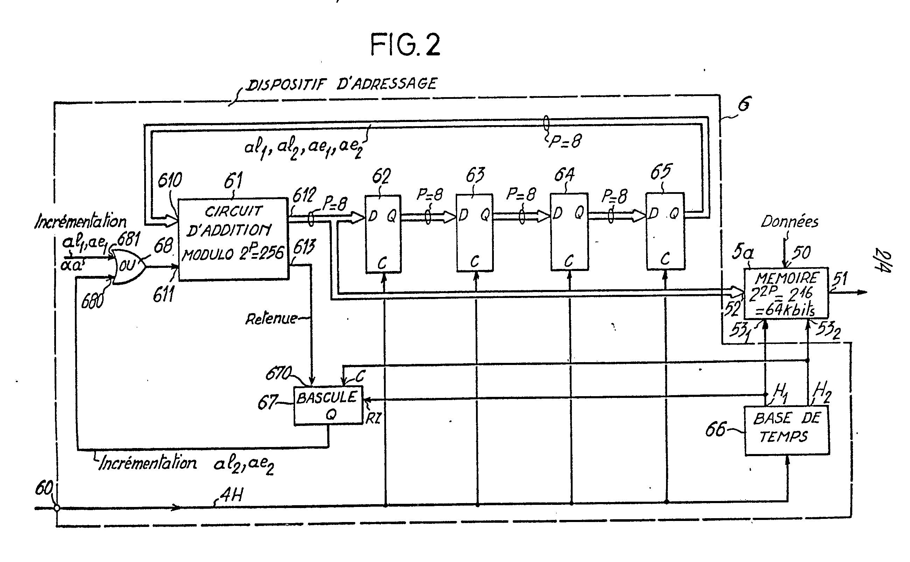

Selon une première réalisation montrée à la fig. 2, une mémoire 5a est adressable en écriture et lecture alternées pendant une période d'un signal d'horloge H au moyen d'un dispositif d'adressage 6. Dans la suite, H désigne également la fréquence du signal d'horloge H.

Le dispositif d'adressage 6 comprend essentiellement un circuit d'addition module $2^P$ (= 256), 61, ayant un bus d'entrée 610 à P = 8 fils et une simple entrée 611, et un registre à décalage comprenant quatre étages 62 à 65 bouclés à travers le circuit 61. Chaque étage 62 à 65 est constitué d'une octuple bascule, c'est-à-dire de huit bascules de type D disposées en parallèle. Des entrées D des bascules de la première octuple bascule 62 sont reliées aux fils P = 8 fils d'un bus de sortie 612 du circuit d'addition 61. Des sorties Q de bascules de la dernière octuple bascule 65 sont reliées aux P = 8 fils du bus d'entrée 610 du circuit 61.

Des entrées d'horloge C de toutes les bascules 62 à 65 reçoivent un signal d'horloge à la fréquence 4H à travers une entrée 60 du dispositif 6. Comme on le verra dans la suite, le bus de sortie 612 qui est relié à P = 8 entrées d'adresse 52 de la mémoire 5a, transmet successivement un premier mot d'adresse de lecture $al_1$, un second mot d'adresse de lecture $al_2$, un premier mot d'adresse d'écriture $ae_1$ et un second mot d'adresse d'écriture $ae_2$ respectivement pendant quatre périodes successives du signal 4H. Les mots $al_1$ et $al_2$ sont deux mots à 8 bits composant un mot d'adresse de lecture al, et les mots $ae_1$ et $ae_2$ sont deux mots à 8 bits composant un mot d'adresse d'écriture ae.

Le dispositif d'adressage 6 comprend également une base de temps auxiliaire 66 incluant des diviseurs de fréquence, une bascule du type D 67 et une porte OU à deux entrées 68.

La base de temps 66 reçoit le signal d'horloge 4H et délivre deux signaux d'horloge complémentaires $H_1$ et $H_2$ ayant une fréquence 2H à des entrées $53_1$ et $53_2$ de la mémoire 5a. Le signal $H_1$ est synchrone avec les mots de bits de poids faible $al_1$ et $ae_1$ dans le bus d'entrée 52, et le signal $H_2$ est synchrone avec les mots de bits de poids fort $al_2$ et $ae_2$ dans le bus 52. Les signaux $H_1$ et $H_2$ permettent ainsi de différencier les bits d'adresse de poids faible et de poids fort et donc d'adresser en écriture et en lecture une cellule de mémoire par des rangées et colonnes correspondantes dans la mémoire 5a.

Une sortie de retenue 613 du circuit 61 est reliée à une entrée 670 de la bascule 67. Une entrée de remise à zéro RZ et une entrée d'horloge C de la bascule 67 reçoivent respectivement les signaux d'horloge $H_1$ et $H_2$ de la base de temps 66. Dans ces conditions, lorsqu'un mot de bits de poids faible $ae_1$, $al_1$, égal à $2^P - 1 = 255$ et sortant de la bascule 65 est appliqué au bus d'entrée 610 du circuit d'addition, le bus de sortie 612 délivre un mot de bit de poids faible $al_1$, $ae_1$ égal à zéro grâce à l'opération modulo-256 dans le circuit 61, lorsqu'un «1» est appliqué à l'entrée 611. Simultanément, la sortie de retenue 613 applique un «1» à l'entrée 670 de la bascule 67. Puis en réponse à une impulsion du signal d'horloge $H_2$ correspondant à la transmission d'un mot de bits de poids fort $al_2$, $ae_2$ par la bascule 65, la bascule 67 applique un «1» à l'entrée 611 du circuit 61 afin d'incrémenter d'une unité le mot de bits de poids fort $al_2$, $ae_2$ succédant au mot de bits de poids faible $al_1$, $ae_1$ ayant des bits tous égaux à «1» et égal à $2^P - 1 = 255$. La bascule 67 délivre ainsi une retenue d'un bit après 256 additions successives relatives aux mots de lecture $al_1$ ou d'écriture $ae_1$. La sortie Q de la bascule 67 étant reliée à l'entrée 611 du circuit 61 à travers la porte OU 68, un bit «1» est additionné au mot respectif $al_2$, $ae_2$ sortant de l'octuple bascule 65 en réponse à l'impulsion précitée du signal $H_2$. La bascule 67 est remise à zéro en réponse à chaque impulsion du signal $H_1$ afin de ne pas perturber une addition d'une unité aux mots $ae_1$ et $al_1$, comme indiqué ci-dessous.

Comme on le voit dans la fig. 2, la porte OU 68 a une entrée 680 reliée à la sortie Q de la bascule 67, et une autre entrée recevant un signal numérique prédéterminé $\alpha a$. Le signal $\alpha a$ transmet normalement des bits synchrones avec le signal $H_1$ afin d'appliquer un «1» à l'unité 611 du circuit d'addition 61 lorsque le bus d'entrée 610 reçoit un mot de bits de poids faible $al_1$, $ae_1$. Entre deux impulsions de signal $H_1$, le signal $\alpha a$ est à l'état «0» en correspondance avec le signal $H_2$. Le signal $\alpha a$ permet d'incrémenter d'une unité les mots $al_1$ et $ae_1$ chaque fois qu'ils sont appliqués au circuit 61.

Ainsi au cours de quatre périodes successives du signal d'horloge 4H ont lieu un transfert de

chaque mot $al_1$, $al_2$, $ae_1$, $ae_2$ à travers les étages 62, 63, 64 et 65 et le circuit d'addition 61 ainsi qu'une réception de ces mots par l'entrée 52 de la mémoire 5a et donc une lecture d'un mot de donnée et une écriture d'un autre mot de donnée relatives à des cellules de mémoire ayant pour adresse $al_1$ + 256 $al_2$ et $ae_1$ + 256 $ae_2$. On notera que les adresses de lecture et d'écriture pendant une période du signal H peuvent être différentes. Pendant des première et troisième périodes du signal 4H, les mots de bits de poids faible $al_1$ et $ae_1$ sont délivrés par le bus de sortie Q de la dernière octuple bascule 65 et sont incrémentés d'une unité dans le circuit 61 lorsque le signal $\alpha a$ est à l'état «1». Si le signal $\alpha a$ est à l'état «0», le mot correspondant $al_1$, $ae_1$ est retransmis par le bus de sortie 612 vers le bus D de la bascule 62 et le bus d'entrée 52 de la mémoire 5a ce qui permet de répéter une lecture d'un même mot de données transmis en sortie 51 ou une écriture de mot de données en entrée 50 dans une même cellule de la mémoire 5a. Pendant des secondes et quatrième périodes du signal 4H, les mots de bits de poids fort $al_2$ et $ae_2$ sont délivrés par le bus de sortie Q de la dernière octuple bascule 65 et ne sont incrémentés d'une unité dans le circuit 61 que lorsque la sortie de Q de la bascule 67 est à l'état «1», c'est-à-dire lorsque le mot précédent respectif de bits de poids faible $al_1$, $ae_1$ sortant de l'octuple bascule 65 est égal à 255. Le tableau I ci-dessous résume les incrémentations possibles pendant une période du signal d'horloge H.

Tableau I

| | H | | | |
|---|---|---|---|---|
| | $H_1$ | $H_2$ | $H_1$ | $H_2$ |
| bus 612-52 | $al_1$ | $al_2$ | $ae_1$ | $ae_2$ |
| $\alpha a$ | «1» ou «0» | «0» | «1» ou «0» | «0» |
| sortie Q de la bascule 68 | «0» «1» si $al_1$=255 | «0» si $al_1$=255 | «0» «1» si $ae_1$=255 | «0» si $ae_1$=255 |

Selon d'autres variantes de la fig. 2, le bus d'adresse 52 de la mémoire 5a peut être reliée au bus de sortie Q de l'une des octuples bascules 62 à 65 et les signaux d'horloge $H_1$ et $H_2$ sont modifiés en conséquence.

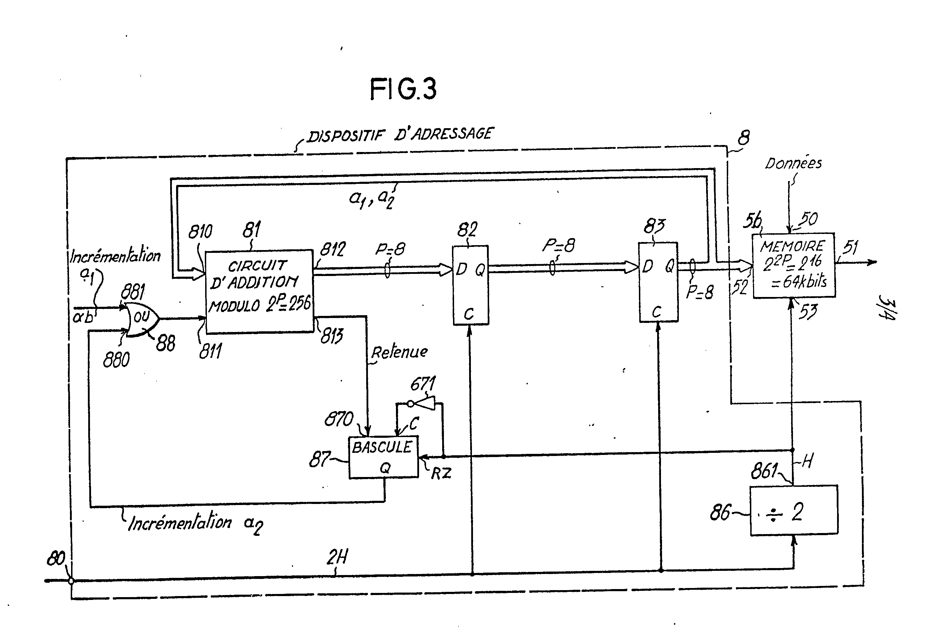

Selon une réalisation illustrée à la fig. 3, une mémoire dynamique 5b est adressable simultanément en lecture et écriture par un dispositif d'adressage 8. En d'autres termes, chaque cellule de la mémoire 5b est adressable en lecture et écriture par un même mot d'adresse $a = a_1 + 256 a_2$ composé de deux mots à 8 bits parallèles $a_1$ et $a_2$ appliqués consécutivement au bus d'entrée 52 de la mémoire 5b. La fréquence de lecture-écriture est toujours égale à H. Dans ce cas, le dispositif d'adressage 8 comprend deux octuples bascules en série 82 et 83 et une base de temps 86 recevant un signal d'horloge 2H via une entrée 80 du dispositif 8. La base de temps 86 est constituée par un diviseur de fréquence par 2, et offre une sortie 861 appliquant un signal d'horloge H à une entrée d'horloge 53 de la mémoire 5b afin de distinguer les mots de bits de poids faible $a_1$ et les mots de bits de poids fort $a_2$.

Le dispositif 8 comprend également un circuit d'addition modulo-256, 81, une bascule 87 et une porte OU à deux entrées 88 qui sont interconnectés comme les circuits 61, 67 et 68 dans le dispositif 6. Un bus de sortie Q à 8 bits de la seconde octuple bascule 83 est reliée au bus d'adresse 52 de la mémoire 5b et à un bus d'entrée 810 du circuit 81. Un bus de sortie à 8 bits 812 du circuit d'addition 81 est reliée à un bus d'entrée D de la première octuple bascule 82. Une sortie de retenue 813 du circuit 81 est reliée à une entrée 870 de la bascule 87. Selon d'autres variantes, les bus 812 ou un bus de sortie Q de la bascule 82 est relié au bus 52.

La bascule 87 fonctionne comme la bascule 67 et présente une entrée de remise à zéro RZ et une entrée d'horloge C reliées directement et à travers un inverseur 671 à la sortie 861 de la base de temps 86 respectivement.

La porte OU 88 a une entrée 880 reliée à une sortie Q de la bascule 87 afin d'incrémenter d'une unité un mot $a_2$ entrant dans le circuit 81 chaque fois que le mot $a_1$ entrant dans le circuit 81 et précédant le mot précité $a_2$ au cours d'une même période de signal H est égal à $2^P - 1 = 255$. Une entrée 881 de la porte OU 88 reçoit un signal $\alpha b$ ayant des bits synchrones avec les mots de bits de poids faible $a_1$ délivrés par le bus de sortie Q de la bascule 83 afin d'incrémenter d'une unité ou de répéter les mots $a_1$.

Le dispositif d'adressage 8 est utilisé pour une mémoire vive RAM à lecture et écriture simultanées, telle qu'une mémoire tampon organisée en file FIFO ou en pile LIFO, mais également pour une mémoire morte ROM, ou analogues du type PROM, EPROM, EEPROM, EAROM, adressable uniquement en lecture.

Le dispositif d'adressage 8 peut être également utilisé pour adresser simultanément deux mémoires vives dont l'une est commandée en lecture et l'autre en écriture et réciproquement. Par exemple, si les deux mémoires sont des mémoires tampon propres à mémoriser chacune une trame d'image d'un signal vidéo numérique, l'une des mémoires reçoit les mots d'adresses $a_1$ $a_2$ en tant que mots de lecture pour lire et délivrer une trame impaire d'image pendant que l'autre reçoit les mots d'adresse $a_1$ $a_2$ en tant que mots d'écriture pour écrire et mémoriser une trame paire d'image. Réciproquement, au cours de la période de trame suivante, la première mémoire écrit et mémorise une trame impaire suivante pendant que la seconde mémoire lit et délivre la trame paire précédemment mémorisée. Selon d'autres variantes, les deux mémoires mémorisent alternativement des images complètes successives au lieu de trames d'image.

Cependant, dans des systèmes de transmission numérique d'images de télévision, un traitement interimage et/ou un infraimage est nécessaire afin de réaliser une réduction de débit numérique du signal vidéo avant transmission en ligne. Par exemple pour du traitement interimages du type à rafraîchissement conditionnel, la mémoire d'image de transmission est une mémoire vive adressable simultanément en lecture et écriture comme la mémoire 5b.

Dans d'autres systèmes de transmission numérique d'images de télévision en couleurs, propre à transmettre un signal vidéo numérique dans un canal à 34 Mbit/s, la mémoire d'image doit être adressée en écriture à une cadence plus rapide qu'en lecture, ce qui revient à répéter une ou plusieurs adresses de lecture prédéterminées.

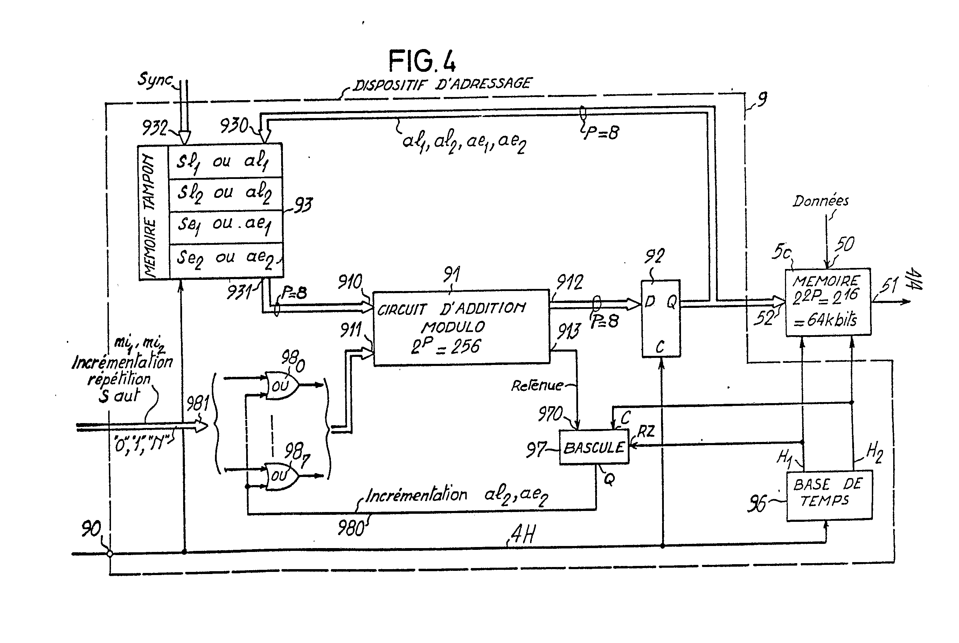

La fig. 4 montre un dispositif d'adressage 9 qui peut être adapté pour une mémoire d'image 5c du type ci-dessus. En fait, le dispositif d'adressage 9 selon une troisième réalisation peut être utilisé pour répéter et/ou supprimer en lecture et/ou en écriture une ou des adresses prédéterminées.

Le dispositif d'adressage 9 est sensiblement analogue au dispositif 6. Le dispositif 9 comprend une boucle fermée dans laquelle circulent les mots d'adresse de lecture $al_1$, $al_2$ et les mots d'adresse d'écriture $ae_1$, $ae_2$. La boucle est constituée par un circuit d'addition modulo-256, 91, une octuple bascule 92 et une mémoire tampon 93. Un bus de sortie 912 du circuit 91 est relié à un bus d'entrée 52 de la mémoire de mots de données 5c et à un bus d'entrée 930 de la mémoire tampon 93 à travers la bascule 92. La mémoire 93 est du type FIFO par exemple et contient quatre cellules de 8 bits chacune permettant d'écrire et de lire successivement les mots d'adresse $al_1$, $al_2$, $ae_1$ et $ae_2$. Un bus de sortie 931 de la mémoire 93 est relié à un bus d'entrée à 8 fils 910 du circuit 91. Comme dans le dispositif 6, une entrée 90 du dispositif 9 applique le signal d'horloge 4H à une base de temps 96 identique à la base de temps 66 délivrant les signaux $H_1$ et $H_2$, à la mémoire 93 et à la bascule 92.

Des moyens d'incrémentation des mots d'adresse dans le dispositif 9 peuvent être prévus d'une manière analogue à l'ensemble des circuits 61, 67 et 68.

La mémoire tampon 93 comprend également un second bus d'entrée à 8 fils 932 permettant de remplacer l'un des mots $al_1$, $al_2$, $ae_1$ et $ae_2$ transmis par la bascule 92 et écrit dans la mémoire 93 par l'un des mots de synchronisation $SI_1$, $SI_2$, $Se_1$ et $Se_2$ respectivement. Le remplacement est effectué entre une écriture et une lecture du mot à remplacer, soit pendant au plus une durée égale à 3 périodes consécutives du signal 4H. Les mots $SI_1$ et $SI_2$ sont constitués par les huit bits de poids faible et les huit de poids fort d'un mot de synchronisation de lecture SI, permettant de synchroniser en lecture les mots de données, ou plus précisément une image ou une trame d'image, mémorisées dans la mémoire 5c. Les mots $Se_1$ et $Se_2$ sont constitués par les huit bits de poids faible et les huit de poids fort d'un mot de synchronisation d'écriture Se permettant de synchroniser en écriture les mots de données dans la mémoire 5c. Après l'une des synchronisations précédentes, c'est-à-dire après l'écriture et la lecture du mot SI, Se dans la mémoire 93, l'adressage respectif en lecture ou en écriture de la mémoire 5c est poursuivi à partir de la cellule de mémoire adressée par le mot respectif SI, Se.

Selon la réalisation illustrée à la fig. 4, les moyens d'incrémentation sont sensiblement modifiés par rapport à ceux du dispositif 6. Le dispositif 9 comprend également une bascule 97 ayant une entrée 970 reliée à une sortie de retenu 913 du circuit d'addition 91. Cependant, la porte OU 68 est remplacée par huit portes OU à deux entrées $98_0$ à $98_7$ reliées à un second bus d'entrée à 8 fils 911 du circuit 9. Des premières entrées 980 des portes $98_0$ à $98_7$ sont reliées à la sortie Q de la bascule 97. Des secondes entrées des portes $98_0$ à $98_7$ sont reliées à un bus 981 transmettant des mots d'incrémentation mi composés chacun d'un mot de 8 bits de poids faible $mi_1$ et d'un mot de 8 bits de poids fort $mi_2$. Les mots $mi_1$ et $mi_2$ sont respectivement synchrones avec les mots $al_1$, $ae_1$ et $al_2$, $ae_2$ respectivement.

Lorsqu'un mot mi est égal à 1, un mot $al_1$ ou $ae_1$ appliqué simultanément sur le premier bus d'entrée 910 du circuit d'addition 91 est incrémenté d'une unité, comme dans le circuit 61. Dans ce cas, le mot mi est composé d'un premier mot $mi_1$ égal à 1 et d'un second mot $mi_2$ égal à 0. Lorsqu'un mot mi a des bits tous égaux à 0 et est donc composé de mots $mi_1$ et $mi_2$ égaux à 0, un mot al ou ae appliqué sur le bus 910 est retransmis tel quel par la sortie de bus 912 du circuit 91. Une répétition successive de mots mi égaux à zéro et synchrones avec les mots d'adresse de lecture al ou d'écriture ae permet de lire ou d'écrire plusieurs fois dans la même cellule de mémoire.

Le mot d'incrémentation mi peut être égal à un entier N inférieur ou égal à $A = 2^{16} - 1 = 65\ 535$. Dans ce cas, le mot mi permet d'effectuer des sauts de N adresses consécutifs et de passer de l'adresse précédente al ou ae délivrée par la mémoire 93 à l'adresse suivante al + N ou ae + N, en vue de supprimer une partie de l'information contenue dans la mémoire 5c.

On notera que les éléments 61, 67 et 68 dans le dispositif 6 montré à la fig. 2 peuvent être remplacés par les circuits 91, 97 et $98_0$ à $98_7$ montrés à la fig. 4.

Par ailleurs, la mémoire 93 peut être remplacée par une mémoire à deux cellules de 8 bits chacune afin de réaliser un dispositif d'adressage à écriture et lecture simultanées analogues au dispositif 8 montré à la fig. 3.

**Revendications**

1. Dispositif d'adressage (6, 8, 9) d'une mémoire (5a, 5b, 5c) adressable par des mots d'adresse (al; ae) au rythme d'une période d'horloge prédéterminée (1/H), chaque mot d'adresse (al; ae) étant composé de premier et second mots d'adresse ($al_1$, $al_2$; $ae_1$, $ae_2$) constitués par des bits de poids faible et des bits de poids fort du mot d'adresse respectivement, les premiers et seconds mots d'adresse étant multiplexés, caractérisé en ce qu'il comprend des moyens (61, 81, 91) pour incrémenter les premiers mots d'adresse (al$_1$, ae$_1$) en fonction d'un signal numérique prédéterminé ($\alpha$a, $\alpha$b, $\alpha$c) ayant des mots («0», «1», N) synchrones avec les premiers mots d'adresse et pour incrémenter le second mot (al$_2$, ae$_2$) de chaque mot d'adresse (al, ae) d'une unité chaque fois que le premier mot (al$_1$, ae$_1$) dudit mot d'adresse a des bits tous égaux à «1», et des moyens à décalage (62–65; 82, 83; 92, 93) bouclés à travers les moyens pour incrémenter (61, 81, 91) pour délivrer lesdits premiers et seconds mots d'adresse multiplexés (al$_1$, al$_2$; ae$_1$, ae$_2$) vers la mémoire (5a, 5b, 5c).

2. Dispositif conforme à la revendication 1, caractérisé en ce que les moyens pour incrémenter (61, 81, 91) comprennent des moyens (61, 81, 91) pour additionner chaque premier mot d'adresse (al$_1$; ae$_1$) sortant des moyens à décalage (62–65; 82, 83; 92, 93) et un mot («0», «1», N) dudit signal numérique prédéterminé ($\alpha$a, $\alpha$b, $\alpha$c) en un premier mot d'adresse entrant dans les moyens à décalage, des moyens (67; 87; 97) pour détecter des premiers mots d'adresse sortants (ae$_1$, al$_1$) ayant des bits tous égaux à «1», et des moyens (61, 81, 91) pour additionner une unité à chaque second mot d'adresse (al$_2$, ae$_2$) sortant des moyens à décalage (62–65; 82, 83; 92, 93) et succédant à un premier mot d'adresse sortant (ae$_1$, al$_1$) ayant des bits tous égaux à «1».

3. Dispositif conforme à la revendication 2, caractérisé en ce que lesdits premiers et seconds mots d'adresse (al$_1$, ae$_1$; al$_2$, ae$_2$) ont chacun P bits et en ce que les moyens pour additionner (61, 81, 91) sont un circuit d'addition modulo-2$^P$ ayant une sortie de retenue (613, 813, 913) reliée aux moyens pour détecter (67, 87, 97).

4. Dispositif conforme à la revendication 2 ou 3, caractérisé en ce que les moyens pour détecter comprennent une bascule (67, 87, 97) ayant une sortie délivrant un bit «1» à une entrée (611, 811, 911) des moyens pour additionner (61, 81, 91) à travers une porte OU (68, 88, 98) chaque fois qu'un premier mot (ae$_1$, al$_1$ sortant des moyens à décalage (62–65; 82, 83; 92, 93) ayant des bits tous égaux à «1» est appliqué à une seconde entrée (610, 810, 910) des moyens pour additionner, la porte OU (68, 88, 98) recevant également ledit signal prédéterminé ($\alpha$a, $\alpha$b, $\alpha$c).

5. Dispositif conforme à l'une quelconque des revendications 1 à 4, caractérisé en ce que le signal prédéterminé ($\alpha$a, $\alpha$b, $\alpha$c) a des mots égaux à 0, 1 et à des entiers (N) respectivement synchrones avec les premiers et seconds mots d'adresse (al$_1$, ae$_1$; al$_2$, ae$_2$).

6. Dispositif conforme à l'une quelconque des revendications 1 à 5, caractérisé en ce qu'un mot d'adresse (al, ae) est répété par les moyens pour incrémenter (61, 81, 91) lorsqu'un mot du signal prédéterminé ($\alpha$a, $\alpha$b, $\alpha$c) égal à 0 est appliqué aux moyens pour incrémenter (61, 81, 91).

7. Dispositif conforme à l'une quelconque des revendications 1 à 6, caractérisé en ce qu'un saut de mot d'adresse (al, ae) est effectué par les moyens pour incrémenter (61, 81, 91) lorsqu'un mot du signal prédéterminé ($\alpha$a, $\alpha$b, $\alpha$c) égal à un entier (N) est appliqué aux moyens pour incrémenter (61, 81, 91).

8. Dispositif conforme à l'une quelconque des revendications 1 à 7, caractérisé en ce que les moyens à décalage comportent aux moins deux ou quatre étages à bascules (82, 83; 62 à 65) ou analogues (93) rythmés à la moitié ou au quart de la période d'horloge et propres à mémoriser chacune un premier ou second mot d'adresse (al$_1$, al$_2$, ae$_1$, ae$_2$).

9. Dispositif conforme à l'une quelconque des revendications 1 à 8, caractérisé en ce que les moyens à décalage (92, 93) comprenant des moyens pour remplacer au moins un mot d'adresse (al$_1$, al$_2$, ae$_1$, ae$_2$) par un mot d'adresse prédéterminé (Sl$_1$, Sl$_2$, Se$_1$, Se$_2$) afin de synchroniser au moins l'une des opérations de lecture ou d'écriture dans la mémoire (5c) à partir du mot d'adresse prédéterminé.

10. Dispositif conforme à l'une quelconque des revendications 1 à 9, caractérisé en ce que pendant chaque période d'horloge (1/H), uniquement un mot d'adresse (a) composé d'un premier et second mot (a$_1$, a$_2$) est délivré par le dispositif (8) vers la mémoire (5b) en vue d'adresser simultanément en lecture et écriture ladite mémoire (5b).

11. Dispositif conforme à l'une quelconque des revendications 1 à 10, caractérisé en ce que pendant une période d'horloge(1/H), un mot d'adresse de lecture (al) et un mot d'adresse d'écriture (ae) composés chacun de premiers et seconds mots (al$_1$, al$_2$; ae$_1$, ae$_2$) sont délivrés par le dispositif (6, 9) vers la mémoire (5a, 5c) en vue d'adresser alternativement en lecture et écriture ladite mémoire (5a, 5c).

**Patentansprüche**

1. Adressiervorrichtung (6, 8, 9) für einen durch Adresswörter (al; ae) adressierbaren Speicher (5a, 5b, 5c) im Takt einer vorbestimmten Taktgeberperiode (1/H), wobei jedes Adresswort (al; ae) aus einem ersten und einem zweiten Adresswort (al$_1$, al$_2$; ae$_1$, ae$_2$) zusammengesetzt ist, die durch niederwertige Bits und hochwertige Bits des jeweiligen Adresswortes gebildet sind, wobei die ersten und zweiten Adresswörter gemultiplext werden, dadurch gekennzeichnet, dass sie Mittel (61, 81, 91) zum Inkrementieren der ersten Adresswörter (al$_1$; ae$_1$) in Abhängigkeit von einem vorbestimmten numerischen Signal ($\alpha$a, $\alpha$b, $\alpha$c), das mit den ersten Adresswörtern synchrone Wörter («0», «1», N) aufweist, und zum Inkrementieren des zweiten Wortes (al$_2$, ae$_2$) eines jeden Adresswortes (al, ae) einer Einheit jedesmal, wenn das erste Wort (al$_1$; ae$_1$) des Adresswortes Bits sämtlich gleich «1» aufweist, und über die Mittel zum Inkrementieren (61, 81, 91) zur Schleife geschaltete Verschiebemittel (62–65; 82, 83; 92, 93) umfasst, um die gemultiplexten ersten und zweiten Adresswörter (al$_1$, al$_2$; ae$_2$, ae$_2$) zum Speicher (5a, 5b, 5c) abzugeben.

2. Vorrichtung nach Anspruch 1, dadurch gekennzeichnet, dass die Mittel zum Inkrementieren (61, 81, 91) Mittel (61, 81, 91) zum Addieren jedes ersten Adresswortes ($al_1$; $ae_1$), die von den Verschiebemitteln (62–65; 82, 83; 92, 93) ausgehen und eines Wortes («0», «1», N) des vorbestimmten numerischen Signals ($\alpha a$, $\alpha b$, $\alpha c$) zu einem ersten Adresswort, das in die Verschiebemittel eintritt, Mittel (67; 87; 97) zum Erfassen der ersten austretenden Adresswörter ($ae_1$, $al_1$), die Bits sämtlich gleich «1» aufweisen, und Mittel (61, 81, 91) zum Addieren einer Einheit zu jedem zweiten Adresswort ($al_2$, $ae_2$) umfassen, die aus den Verschiebemitteln (62–65; 82, 83; 92, 93) austreten und auf ein erstes austretendes Adresswort ($ae_1$, $al_1$) folgen, das Bits sämtlich gleich «1» aufweist.

3. Vorrichtung nach Anspruch 2, dadurch gekennzeichnet, dass die ersten und zweiten Adresswörter ($al_1$, $ae_1$; $al_2$, $ae_2$) jeweils P Bits aufweisen und dass die Mittel zum Addieren (61, 81, 91) eine Modul-$2^P$-Addierschaltung sind, die einen mit den Mitteln zum Erfassen (67, 87, 97) verbundenen Übertragsausgang (613, 813, 913) aufweist.

4. Vorrichtung nach Anspruch 2 oder 3, dadurch gekennzeichnet, dass die Mittel zum Detektieren eine Kippeinheit (67, 87, 97) umfassen, die einen Ausgang aufweist, der ein Bit «1» an einen Eingang (611, 811, 911) der Mittel zum Addieren (61, 81, 91) über ein ODER-Gatter (68, 88, 98) jedesmal ausgibt, wenn ein aus den Verschiebemitteln (62–65; 82, 83; 92, 93) austretendes erstes Wort ($\alpha a$, $\alpha b$, $\alpha c$), dessen Bits sämtlich gleich «1» sind, an einen zweiten Eingang (610, 810, 910) der Mittel zum Addieren angelegt wird, wobei das ODER-Gatter (68, 88, 98) ebenso das vorbestimmte Signal ($\alpha a$, $\alpha b$, $\alpha c$) empfängt.

5. Vorrichtung nach einem beliebigen der Ansprüche 1 bis 4, dadurch gekennzeichnet, dass das vorbestimmte Signal ($\alpha a$, $\alpha b$, $\alpha c$) Wörter gleich 0, 1 und ganzen Zahlen (N) jeweils synchron mit den ersten und zweiten Adresswörtern ($al_1$, $ae_1$; $al_2$, $ae_2$) hat.

6. Vorrichtung nach einem beliebigen der Ansprüche 1 bis 5, dadurch gekennzeichnet, dass ein Adresswort (al, ae) durch die Mittel zum Inkrementieren (61, 81, 91) wiederholt wird, wenn ein Wort des vorbestimmten Signals ($\alpha a$, $\alpha b$, $\alpha c$) gleich 0 an die Mittel zum Inkrementieren (61, 81, 91) angelegt wird.

7. Vorrichtung nach einem beliebigen der Ansprüche 1 bis 6, dadurch gekennzeichnet, dass ein Sprung des Adressworts (al, ae) durch die Mittel zum Inkrementieren (61, 81, 91) bewirkt wird, wenn ein Wort des vorbestimmten Signals ($\alpha a$, $\alpha b$, $\alpha c$) gleich einer ganzen Zahl (N) an die Mittel zum Inkrementieren (61, 81, 91) angelegt wird.

8. Vorrichtung nach einem beliebigen der Ansprüche 1 bis 7, dadurch gekennzeichnet, dass die Verschiebemittel wenigstens zwei oder vier Kipp- (82, 83; 62–65) oder analoge (93) Stufen umfassen, die mit der Hälfte oder einem Viertel der Taktgeberperiode gesteuert und jeweils geeignet sind, ein erstes oder ein zweites Adresswort ($al_1$, $al_2$; $ae_1$, $ae_2$) zu speichern.

9. Vorrichtung nach einem beliebigen der Ansprüche 1 bis 8, dadurch gekennzeichnet, dass die Verschiebemittel (92, 93) Mittel umfassen, um wenigstens ein Adresswort ($al_1$, $al_2$; $ae_1$, $ae_2$) durch ein vorbestimmtes Adresswort ($Sl_1$, $Sl_2$, $Se_1$, $Se_2$) zu ersetzen, um wenigstens die eine von den Lese- oder Schreiboperationen in dem Speicher (5c) vom vorbestimmten Adresswort aus zu synchronisieren.

10. Vorrichtung nach einem beliebigen der Ansprüche 1 bis 9, dadurch gekennzeichnet, dass während jeder Taktgeberperiode (1/H) lediglich ein aus einem ersten und zweiten Wort ($a_1$, $a_2$) zusammengesetztes Adresswort (a) durch die Vorrichtung (8) zum Speichern (5b) zwecks simultaner Adressierung beim Lesen und Schreiben des Speichers (5b) ausgegeben wird.

11. Vorrichtung nach einem beliebigen der Ansprüche 1 bis 10, dadurch gekennzeichnet, dass während einer Taktgeberperiode (1/H) ein Leseadresswort (al) und ein Schreibadresswort (ae), die jeweils aus ersten und zweiten Wörtern ($al_1$, $al_2$; $ae_1$, $ae_2$) zusammengesetzt sind, durch die Vorrichtung (6, 9) zum Speichern (5a, 5c) zwecks abwechselnder Adressierung beim Lesen und Schreiben des Speichers (5a, 5c) ausgegeben werden.

**Claims**

1. Adressing device (6, 8, 9) for a memory (5a, 5b, 5c) addressable by address words (al; ae) at a predetermined clock-period rate (1/H), each address word (al; ae) being made up of first and second address words ($al_1$, $al_2$; $ae_1$, $ae_2$) composed of least significant bits and most significant bits of the address word respectively, the first and second address words being multiplexed, characterized in that it comprises means (61, 81, 91) for incrementing the first address words (al, $ae_1$) in terms of a predetermined digital signal ($\alpha a$, $\alpha b$, $\alpha c$) carrying words («0», «1», N) synchronous with the first address words and for incrementing the second word ($al_2$, $ae_2$) in each address word (al, ae) by one unity whenever the first word ($al_1$, $ae_1$) of said address word has bits all equal to «1», and shift means (62 – 65; 82, 83; 92, 93) looped across the incrementing means (61, 81, 91) in order to deliver said first and second multiplexed address words ($al_1$, $al_2$; $ae_1$, $ae_2$) to the memory (5a, 5b, 5c).

2. Device according to claim 1, characterized in that the incrementing means (61, 81, 91) comprise means (61, 81, 91) for adding each first address word ($al_1$; $ae_1$) outgoing from the shift means (62 – 65; 82, 83; 92, 93) and a word («0», «1», N) of said predetermined digital signal ($\alpha a$, $\alpha b$, $\alpha c$) into a first address word entering the shift means, means (67; 87; 97) for detecting first outgoing address words ($ae_1$, $al_1$) carrying bits all equal to «1», and means (61, 81, 91) for adding one unity to each second address word ($al_2$, $ae_2$) outgoing from the shift means (62 – 65; 82, 83;

92, 93) and following a first outgoing address word ($ae_1$, $a_1$l) carrying bits all equal to «1».

3. Device according to claim 2, characterized in that said first and second address words ($al_1$, $ae_1$; $al_2$, $ae_2$) each have P bits and in that the adding means (61, 81, 91) consist of a modulo-$2^P$ adding circuit having a carry output (613, 813, 913) connected to the detecting means (67, 87, 97).

4. Device according to claim 2 or 3, characterized in that the detecting means comprise a flip-flop (67, 87, 97) carrying an output delivering «1» bit to an input (611, 811, 911) of the adding means (61, 81, 91) through an OR gate (68, 88, 98) whenever one first word ($ae_1$, $al_1$) outgoing from the shift means (62–65; 82, 83; 92, 93) and having bits all equal to «1» is fed to a second input (610, 810, 910) of the adding means, the OR gate (68, 88, 98) also receiving said predetermined signal ($\alpha a$, $\alpha b$, $\alpha c$).

5. Device according to any one of claims 1 to 4, characterized in that the predetermined signal ($\alpha a$, $\alpha b$, $\alpha c$) carried words equal to 0, 1 and integers (CN) respectively synchronous with the first and second address words ($al_1$, $ae_1$; $al_2$, $ae_2$).

6. Device according to any one of claims 1 to 5, characterized in that an address word (al, ae) is repeated by the incrementing means (61, 81, 91) when a word of the predetermined signal ($\alpha a$, $\alpha b$, $\alpha c$) equal to 0 is fed into the incrementing means (61, 81, 91).

7. Device according to any one of claims 1 to 6, characterized in that a skip of address word (al, ae) is made by the incrementing means (61, 81, 91) when a word of the predetermined signal ($\alpha a$, $\alpha b$, $\alpha c$) equal to an integer (N) is fed into the incrementing means (61, 81, 91).

8. Device according to any one of claims 1 to 7, characterized in that the shift means comprise at least two or four flip-flop stages (82, 83; 62 to 65) or the likes (93) timed on half or quarter of the clock period and each capable of storing one first or second address word ($al_1$, $al_2$, $ae_1$, $ae_2$).

9. Device according to any one of claims 1 to 8, characterized in that the shift means (92, 93) comprise means for replacing at least one address word ($al_1$, $al_2$, $ae_1$, $ae_2$) by a predetermined address word ($Sl_1$, $Sl_2$, $Se_1$, $Se_2$) in order to synchronize at least one of the reading or writing operations in the memory (5c) from the predetermined address word.

10. Device according to any one of claims 1 to 9, characterized in that during each clock period (1/H) one address word (a) made up of a first and second word ($a_1$, $a_2$) is only delivered by the device (8) to the memory (5b) with a view to simultaneously addressing said memory (5b) in reading and writing.

11. Device according to any one of claims 1 to 10, characterized in that during each clock period (1/H) one read address word (al) and one write address word (ae) each composed of first and second address words ($al_1$, $al_2$; $ae_1$, $ae_2$) are delivered by the device (6, 9) to the memory (5a, 5c) with a view to alternately addressing said memory (5a, 5c) in reading and writing.

1/4

# FIG.1

COMPTEUR ECRITURE (1)

COMPTEUR LECTURE (2)

Mot d'écriture — 16

16 — Mot de lecture

3 — MULTIPLEXEUR

16

4 — MULTIPLEXEUR

8

5 — MEMOIRE 64 k bits

FIG.2

DISPOSITIF D'ADRESSAGE

# FIG.3

FIG.4

DISPOSITIF D'ADRESSAGE